**Europäisches Patentamt**

**European Patent Office**

**Office européen des brevets**

(11) Veröffentlichungsnummer : **0 417 578 B1**

(19)

(12) **EUROPÄISCHE PATENTSCHRIFT**

(45) Veröffentlichungstag der Patentschrift :
**13.12.95 Patentblatt 95/50**

(21) Anmeldenummer : **90116802.1**

(22) Anmeldetag : **01.09.90**

(51) Int. Cl.⁶ : **G09G 3/36, H04N 3/12**

(54) Ansteuerschaltung für eine Flüssigkristallanzeige

(30) Priorität : **11.09.89 DE 3930259**

(43) Veröffentlichungstag der Anmeldung :
**20.03.91 Patentblatt 91/12**

(45) Bekanntmachung des Hinweises auf die
Patenterteilung :
**13.12.95 Patentblatt 95/50**

(84) Benannte Vertragsstaaten :
**AT BE CH DE DK ES FR GB GR IT LI LU NL SE**

(56) Entgegenhaltungen :
**EP-A- 0 238 867**
**EP-A- 0 298 255**
**GB-A- 2 204 174**

(73) Patentinhaber : **DEUTSCHE
THOMSON-BRANDT GMBH
Hermann-Schwer-Strasse 3
D-78048 Villingen-Schwenningen (DE)**

(72) Erfinder : **Dupont, Antoine, Dipl.-Ing.
Mannheimer Strasse 24
D-7730 Villingen (DE)**
Erfinder : **Maier, Michael, Dipl.-Ing.
Freiersbach 3
D-7605 Bad Peterstal-Griesbach (DE)**
Erfinder : **Hepp, Bernard, Dipl.-Ing.
48 Rue Ybry
F-92200 Neuilly/Seine (FR)**
Erfinder : **Benoit, Eric, Dipl.-Ing.
Wasenstrasse 5
D-7750 Schwenningen (DE)**

(74) Vertreter : **Einsel, Robert, Dipl.-Ing.
Deutsche Thomson-Brandt GmbH
Patent- und Lizenzabteilung
Göttinger Chaussee 76
D-30453 Hannover (DE)**

EP 0 417 578 B1

EP 0 417 578 B1

## Beschreibung

Die Erfindung betrifft eine Ansteuerschaltung für eine Flüssigkristallanzeige.

Bekannte Flüssigkristallanzeigen enthalten zwei Substrate, die in einem definierten Abstand zueinander angeordnet sind. Zwischen den Substraten befindet sich ein Flüssigkeitskristallmaterial. Die Substrate sind so gewählt, daß je nach Anwendung eins oder beide durchsichtig bzw. transparent sind. Auf einem dieser Substrate ist ein transparenter Masseebenenleiter angeordnet. Das gegenüberliegende Substrat enthält eine Matrix von einzelnen Elektrodenelementen, die Pixelelektroden genannt werden. Ein Halbleiterschalter, vorzugsweise ein Dünnfilmtransistor, ist jeder dieser Pixelelektroden zugeordnet und auf dem diese Elektroden enthaltenden Substrat angeordnet. Diese Transistorschalter sind entweder aus amorphem Silicium oder polykristallinen Silicium aufgebaut. Die Technologie mit amorphem Silicium ist wegen der niedrigeren Verfahrenstemperaturen für Konsumeranwendungen vorzuziehen. Die einzelnen Pixelelektroden der Matrix wirken wie Kondensatoren, mit dem Flüssigkeitsmaterial als Dielektrikum. Das Anlegen einer Spannung an einer Pixelelektrode steuert die Lichtdurchlässigkeit des Flüssigkristallmaterials. Diese Transformation bzw. Umgruppierungen der Flüssigkristalle ermöglicht die Anzeige von Text oder graphischer Information, die auf der Vorrichtung sichtbar wird. Jeder Pixelelektrode ist ein eigener Halbleiterschalter zugeordnet, der ein- oder ausgeschaltet werden kann, so daß jedes einzelne Pixelelement durch Signale gesteuert werden kann, die seinem zugeordnetem Halbleiterschalter zugeführt werden.

Jeder Transistor ist Kreuzungspunkt einer Spalte m und einer Zeile n der Matrix. Die Spalten m sind Datenleitungen, die Zeilen n Selektionsleitungen. Die Steuerelektrode eines jeden Transistorschalters ist mit einer Selektionsleitung und die Source- oder Drainelektrode des Transistorschalters mit einer Datenleitung verbunden. Die Drain- oder Sourceelektrode ist mit der Pixelelektrode verbunden.

Im Betrieb wird fortlaufend für das Schreiben einer Zeile ein Signalpegel an jede der Datenleitungen angelegt. Die Abtastleitungen werden fortlaufend aktiviert, damit die auf den Datenleitungen auftretenden Spannungen durch ihre entsprechenden Halbleiterschaltelemente an die Pixelelektroden angelegt werden. Bei der Wiedergabe, z. B. einer Bildinformation werden die z. B. Grauwerte repräsentierenden Spannungen an Datenleitungen gelegt und die Abtastleitungen während der entsprechenden zu schreibenden Zeile aktiviert. Nach einer erforderlichen kurzen Ladezeit des Flüssigkeitskondensators wird eine andere Abtastleitung aktiviert und die für diese Zeile zugeordneten Datenspannungen sequentiell an die Pixelspalten angelegt. Bei Fernsehanwendungen erfolgt dieses Schreiben von oben nach unten in z. B. 1/25 oder 1/50 Sekunden. Somit wird in dieser Zeitperiode ein vollständiges Bild auf dem Schirm angezeigt.

Zu der Kapazität, die der Flüssigkristallkondensator aufweist, gibt es parasitäre Kapazitäten, die die Signalübertragung von den Datenleitungen zu den Flüssigkristallkondensatoren unerwünscht beeinflussen. Zum einen gibt es parasitäre Kapazitäten zwischen den Datenleitungen und der Pixelelektrode, zum anderen die parasitären Gate/Source- und Gate/Drain-Kapazitäten in dem Schaltelement selbst. Im Betrieb einer derartigen Anzeige wird die Spannung auf einem Pixel während ihrer reinen Adressierung gesetzt. Der Halbleiterschalter wird dann gesperrt, und die Spannung sollte so lange konstant bleiben, bis beim erneuten Bildaufbau die Zeile neu beschrieben wird.

Um den Flüssigkristallkondensator auf den durch die Information der Datenleitung vorgegebenen Spannungswert sowie die parasitären Kapazitäten aufzuladen, ist eine Mindestladezeit erforderlich. Diese Ladezeit kann nicht beliebig verkleinert werden, bedingt durch die geringe Mobilität, die das verwendete amorphe Silicium aufweist.

Aus EP-A1-0 298 255 ist eine Ansteuerschaltung für eine Flüssigkristallanzeige bekannt, die aus einer aktiven Matrixanzeige besteht, sowie Signaltreiberschaltungen für die Spalten und die Zeilen enthält. Die Spaltenansteuerschaltung enthält Shift-Register, sowie zwei Sample- and Hold-Schaltungen für jede Spalte. In die erste Sample- and Hold-Schaltung werden sequentiell die Daten einer Zeile eingeschrieben. Nachdem die Zeile geschrieben worden ist, wird ihr gesamter Inhalt an die zweite Sample-and-Hold-Schaltung übergeben, die die Flüssigkristall-Anzeigeelemente ansteuert. Bei diesem Verfahren ist es erforderlich, dafür zu sorgen, daß die Spannung der ersten Spalten über eine lange Zeit konstant gehalten wird, bis die Sample-and-Hold-Schaltung der letzten Spalte geladen ist. Zudem ist für jede Spalte eine eigene Anschlußleitung zu verwenden.

In EP-A-0238867 bilden jeweils eine Gruppe von aufeinanderfolgenden Spalten einen Block. Die zugeführten analogen Bildsignale werden blockweise in Spalten-Kondensatoren solange zwischengespeichert, bis jeweils die Daten einer kompletten Zeile in diesen Spalten-Kondensatoren gespeichert sind. Danach wird diese Zeile zur Anzeige gebracht.

In GB-A-2204174 wird eine Display-Ansteuerschaltung beschrieben, in der die Ansteuersignale pulsbreiten-moduliert sind.

Der Erfindung liegt die Aufgabe zugrunde, eine Ansteuerschaltung für eine Flüssigkristallanzeige anzugeben, die auf einfache Weise die geladene Spannung während einer Zeitdauer konstant hält und dadurch eine

2

gleichmäßige Helligkeitsverteilung über die gesamte Displaybreite ermöglicht und bei der die Anzahl der Anschlußleitungen reduziert ist.

Diese Aufgabe wird durch die im Anspruch 1 angegebenen Merkmale gelöst. Vorteilhafte Weiterbildungen der Erfindung sind in den Unteransprüchen wiedergegeben.

Zur Lösung der Aufgabe wird erfindungsgemäß die Ansteuerschaltung im Multiplexbetrieb betrieben. Dabei wird vor oder nach dem Aufschalten der Datenspannung auf ein Pixelelement die Selektionsleitung der jeweiligen Zeile eingeschaltet und danach oder davor die Datenspannung auf die jeweilige Spalte gegeben. Dazu werden eine Anzahl von Spalten zu Blöcken zusammengefaßt, wobei das Videosignal jeweils eines Blockes auf die jeweiligen Spalten des Anzeigeelements gegeben und das Videosignal blockweise weitergeschaltet wird. Dadurch ergibt sich für den Multiplexbetrieb eine Ladezeit für jedes Pixelelement von der Dauer der Zeile dividiert durch Anzahl der Blöcke. Da die Anzahl der Blöcke erheblich kleiner ist als die Anzahl der Spalten, ist die Ladezeit erheblich größer.

Zur Vermeidung von hohen Spitzenströmen sowie zur Erzielung der gleichmäßigen Helligkeitsverteilung über die gesamte Displaybreite wird das Videosignal zwischengespeichert und alle Kondensatoren der einzelnen Spalten eines Blockes parallel geladen.

Ein erfindungsgemäßes Ausführungsbeispiel wird anhand der Zeichnung erläutert.

Fig. 1    Ansteuerung des Display
Fig. 2    Zwischenspeicherungsanordnung
Fig. 3    Zwischenspeicherungsanordnung mit Stromverstärker
Fig. 4    Blockschaltbild einer Zeit-Spannungswandlung
Fig. 5    Schaltung der Zeit-Spannungswandlung nach Fig. 4
Fig. 6    eine weitere Spannungs-Zeitwandlungsschaltung
Fig. 7    eine Speicherschaltung
Fig. 8    ein erstes Zeitdiagramm
Fig. 9    ein zweites Zeitdiagramm
Fig. 10   eine erweiterte Vorstufe
Fig. 11   ein drittes Zeitdiagramm
Fig. 12   Zeitdiagramm zu Fig. 6

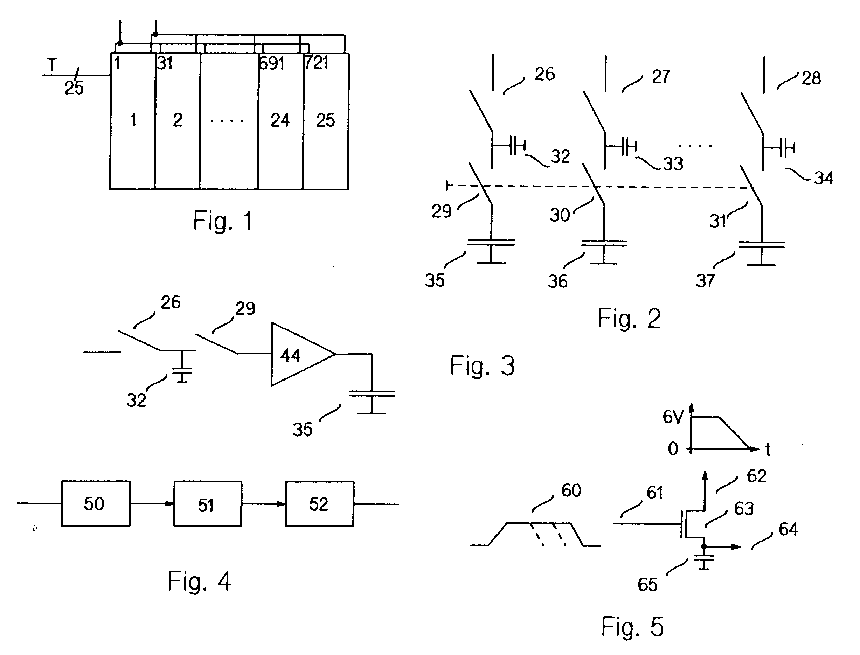

Fig. 1 zeigt die erfindungsgemäße Ansteuerung einer Flüssigkeitskristallanzeige. Die Flüssigkristallanzeige ist in 25 Blöcken 1 - 25 aufgeteilt, mit je 30 vertikalen Ansteuerleitungen. Das Videosignal wird hier jeweils für einen Block parallel auf die 30 Eingangsleitungen 1 - 30 übertragen, wobei Eingangstakte jeweils nach Schreiben der Spalten eines Blocks auf dem nächsten Block umschalten. Bei diesem Multiplexbetrieb ergibt sich pro Block bzw. für ein Pixel die Zeit von $p_{Pixel} = 64\ \mu s\ /\ 25 = 2,5\ \mu s$. Durch die erfindungsgemäße Aufteilung der Ansteuerung der Flüssigkristallelektroden wird eine hinreichend große Zeitspanne für die Ansteuerung der Pixel realisiert. Eine mögliche Ansteuerung der Pixelelektroden kann durch ein direktes Laden der Spaltenkondensatoren eines Blockes erfolgen. Dazu wird jedoch ein sehr hoher Spitzenstrom benötigt, was insgesamt als nachteilig angesehen werden muß. Zudem ist die Helligkeitsverteilung über die gesamte Flüssigkristallanzeigebreite nicht gleichmäßig, da die einzelnen Spalten der Blöcke 1 - 25 nacheinander die Videoinformationen enthalten und die Spannung am Pixelkondensator der Spalten des ersten Blockes schon abgefallen ist, wenn die Spalten des letzten Blockes das Videosignal erhalten.

Erfindungsgemäß wird deshalb das Videosignal zwischengespeichert und ein gemeinsames Laden aller Kondensatoren in den einzelnen Spalten durchgeführt.

Fig. 2 zeigt eine solche Zwischenspeicherschaltung. Block-Schaltern 26, 27, 28 wird das Videosignal im Multiplexbetrieb zugeführt. Die Schalter werden im Multiplexbetrieb blockweise nacheinander geschlossen. In geschlossenem Zustand der Schalter 26, 27, 28 werden Ladekondensatoren 32, 33, 34 nacheinander geladen. Nachdem die Zeile geschrieben ist, d. h. nachdem sämtliche Kondensatoren 32, 33, 34 geladen sind, werden Schaltern 29, 30, 31 gleichzeitig geschlossen, so daß die Speicherkondensatoren 32, 33, 34 mit den Spaltenkondensatoren 35, 36, 37 gleichzeitig verbunden wird. Durch Aktivierung der Selektionsleitung werden die gespeicherten Spannungen zeilenweise auf die Anzeige gegeben.

Fig. 3 zeigt eine Zwischenspeicherschaltung mit einem Stromverstärker 44. Es wird eine Speicherschaltung für eine Spalte gezeigt. Über den Schalter 26 wird der Speicherkondensator 32 geladen. Nachdem alle Speicherkondensatoren der Speicherschaltung während der Zeilendauer blockweise geladen sind, wird der Schalter 29 geschlossen. Der Stromverstärker 44 verstärkt den Entladestrom des Ladekondensators 29 und führt ihn auf den Spaltenkondensator 35.

Fig. 4 zeigt als Stromverstärker 44 eine Schaltung zur Spannungs/Zeit-Spannungswandlung 51, 52 des Videosignals. Beispielsweise ausgehend von einem Spannungsbereich von 0 bis 6 Volt des Videosignals, wird die in einem Speicher 50 gespeicherte Videoinformation, die einen bestimmten Spannungswert darstellt, durch einen Spannungs-Zeitwandler 51 in ein pulsbreitenmoduliertes Signal umgesetzt. Dies pulsbreitenmodulierte Signal wird anschließend durch eine Zeit-Spannungsumwandlungsschaltung 52 den Pixelkondensatoren zugeführt.

Fig. 5 zeigt eine Schaltung zur Zeit-Spannungswandlung. Das pulsbreitenmodulierte Signal 60 wird dem Gate 61 eines Transistors 63 zugeführt. An der Source-Elektrode 62 des Transistors 63 liegt eine Spannung an, die von einem Maximalwert, z. B. 6 Volt, mit einer konstanten Steigung auf 0 Volt abfällt. Ein an der Source-Elektrode angeschlossener Kondensator 65 wird somit mittels dieser Rampenspannung geladen. Als Kondensator können die parasitären Gate/Drain-Kondensatoren der Transistorschalter der nicht aktivierten Zeilen der gleichen Spalte ausgenutzt werden. Der Ausgang des Kondensators 65 wird einer Spalte des Flüssigkeitsanzeigeelements zugeführt. Je nach Höhe der Videoeingangsspannung erhält man einen unterschiedlich langen Impuls des Spannungs-Zeitwandlers 51, so daß am Kondensator 65 die jeweilige Spannung abgreifbar ist.

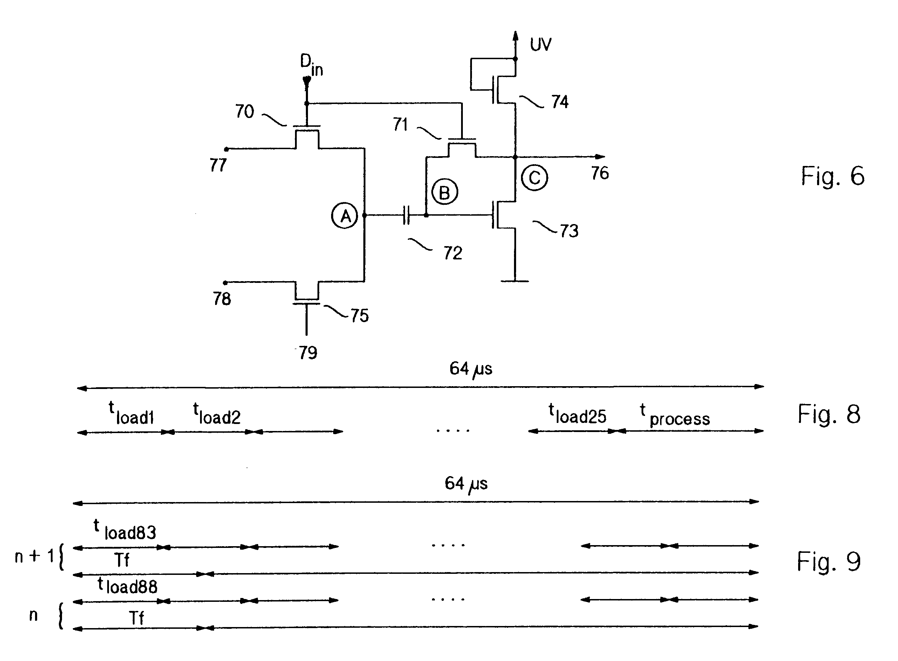

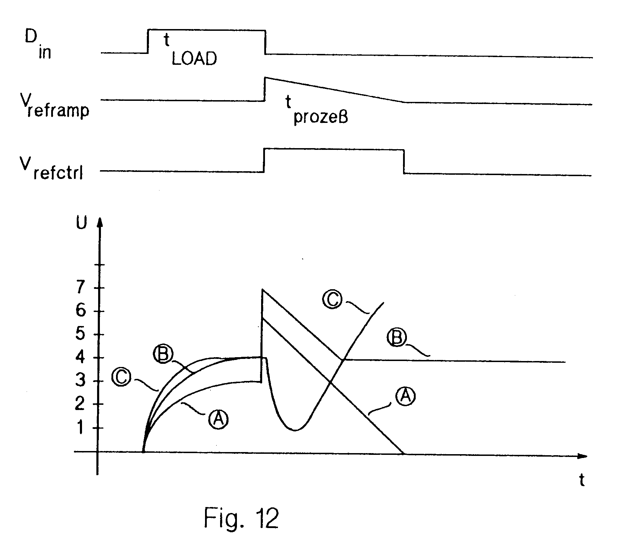

Fig. 6 zeigt eine Schaltung zur Speicherung und Spannung-Zeitwandlung des Videosignals. Fig. 12 gibt das zugehörige Zeitdiagramm wieder. Über einen Eingang 77 werden die Eingangsdaten der Source- bzw. Drainelektrode eines Transistors 70 zugeführt. Der Gate-Elektrode des Transistors 70 wird das Signal zum Umschalten eines Blockes $D_{in}$ zugeführt. Über einen Eingang 78 wird eine Referenzspannung $V_{reframp}$ an die Drain- bzw. Sourceelektrode eines Transitors 75 gelegt, dessen Gate-Elektrode mit einer Kontrollspannung $V_{refctrl}$ 79 für die Referenzspannung $V_{reframp}$ verbunden ist. Beide Ausgangselektroden der Transistoren 70, 75 sind miteinander verbunden, Punkt A, und führen auf einen Kondensator 72. Der zweite Anschluß des Kondensators 72 führt einerseits auf die Drain/Sourceelektrode eines Transistors 71 als auch auf die Gate-Elektrode eines Transistors 73 am Punkt B. Die Gate-Elektrode des Transistors 71 ist mit der Leitung zur Umschaltung eines Blockes verbunden. Eine Elektrode des Transistor 73 ist mit Masse verbunden. Die andere Elektrode des Transistor 73 ist verbunden mit einer zweiten Elektrode des Transistors 71, sowie einer Drain/Source-Elektrode des Transistors 74. Dieser gemeinsame Verbindungspunkt C führt auf einen Ausgang 76 der Schaltung, die ein Ausgangsignal auf die Schaltung zur Zeit/Spannungswandlung z. B. gemäß Fig. 4 führt. Der Transistor 74 ist mit seiner Eingangselektrode mit einer Versorgungsspannung V verbunden. Diese Versorgungsspannung V wird gleichzeitig auf die Gate-Elektrode des Transistors 74 gelegt. Der Kondensator 72 entspricht den Kondensatoren 32, 33, 34 der Fig. 2. Der Kondensator 72 dient zur Zwischenspeicherung des Videosignals.

Zu Beginn der Ladezeit $t_{load}$ sind beide Transistoren 70, 71 leitend. Am Punkt B stellt sich somit eine Gleichgewichtsspannung ein, die nur von der Dimensionierung der Größen der beiden Transistoren 73, 74 abhängig ist, z. B. von der Breite des Kanals der verwendeten FET-Transistoren 73, 74. Diese Schaltung dient als Inverter mit schneller Einschaltung bzw. Abschaltung des Transistors 73. Dazu wird erfindungsgemäß der Kanal des Transistors 74 möglichst klein, der des Transistors 73 möglichst groß gewählt. Der Kondensator 72 wird nun am Punkt A mit der Datenspannung geladen. Ist der Kondensator 72 geladen, so werden die beiden Transistoren 70, 71 abgeschaltet und über den Transistor 75 die Referenzspannung $V_{reframp}$ an Punkt A gelegt.

Die Spannung am Punkt B verändert sich wie folgt:
$$U_B = U_{B0} + U_{ramp} - U_{data}$$
$U_{B0}$ ist in diesem Fall die Spannung, die sich einstellt, wenn der Transistor 71 leitend ist, d. h. die Spannung, die sich durch Dimensionierung der Transistoren 73, 74 einstellt. Es stellt sich somit eine Gleichgewichtsspannung ein. Ausgehend von einer Referenzspannung von 6 Volt mit konstantem Abfall auf 0 Volt, und einer Datenspannung $V_{data}$ = 3 Volt stellt sich am Punkt B folgende Spannung ein:
$$U_B = 4V + 6V - 3V = 7V$$
Da der Kondensator 72 in der nun folgenden Zeit quasi nicht entladen wird, folgt die Spannung $U_B$ der Referenzrampe 78 in einem angenähert parallelem Abstand, der von der Größe der zuerst angelegten Datenspannung $U_{data}$ abhängig ist.

Wird die Spannung $U_B$ kleiner als $U_{B0}$ so sperrt der Transistor 73 und die Spannung am Punkt C wird sehr schnell größer. Diese Spannung am Punkt C wird mit Hilfe eines nicht gezeichneten Inverters invertiert und zur Steuerung des Transistors 63 gemäß Fig. 5 der Schaltung zur Zeit-Spannungswandlung benutzt.

Die Pulsbreiten-Modulation kommt also dadurch zustande, daß die Spannung am Punkt B abhängig von der Datenspannung ist und den Transistor 73 früher oder später sperrt. Die in Fig. 12 gezeigten Spannungsverläufe A, B, C entsprechen für das o. a. Beispiel den Spannungsverläufen an den Punkten A, B, C.

Fig. 8 zeigt den Lade- und Prozeßvorgang in einer Zeile, wie er in Fig. 6 durchgeführt wird. Während der Zeitdauer einer Zeile von 64 µs werden die 25 Blöcke 1 - 25 während gleicher Zeitdauer $t_{load1, ...load25}$ mit dem Datensignal geladen. Die Gesamtladezeit ist kleiner als die Zeitdauer der gesamten Zeile von 64 µs. Ausgehend davon, daß die Prozeßzeit $t_{prozeß}$ = 20 µs beträgt, ergibt sich daraus eine Ladezeit für den Kondensator 72 von 1,7 µs.

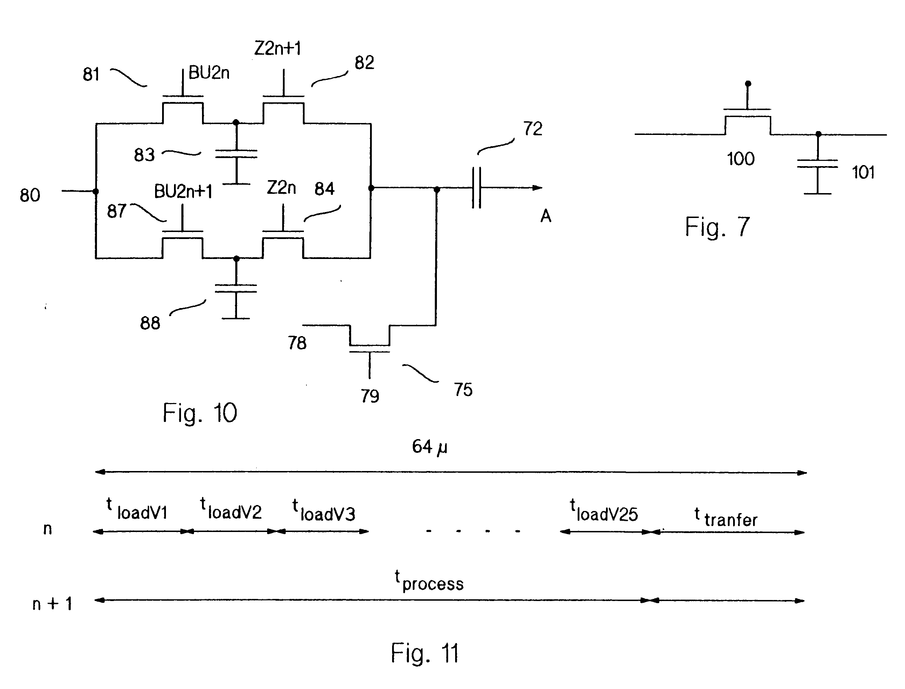

Fig. 7 zeigt eine Vorstufe für die Schaltung nach Fig. 6. Die Eingangsdaten werden einem Transistor 100 zugeführt, dessen Gate-Elektrode durch ein Kontrollsignal zur Zwischenspeicherung angesteuert wird, welches blockweise an die Gate-Elektrode angelegt wird. Die die Daten repräsentierende Spannung wird auf einem Kondensator 101 gespeichert. Diese als Spannungswert gespeicherte Information wird dem Eingang 77 der Schaltung gemäß Fig. 6 zugeführt. Dadurch werden alle 25 Vorstufenblöcke zuerst nacheinander geladen und dann die Daten zusammen in die nächste Schaltung gemäß Fig. 6 übertragen. Während des Ladens der Vorstufe der Zeilen n läuft gleichzeitig gemäß Fig. 11 der Prozeß der Daten der Zeilen n + 1 ab. Die Transferzeit $t_{transfer}$ gemäß Fig. 11 entspricht der Zeit, die in der Schaltung gemäß Fig. 6 zum Laden des Kondensators 72 zur Verfügung steht und z. B. der Zeit $t_{load1}$ gemäß Fig. 8 entspricht. Der Transistor 100 kann bei dieser Vorstufe größer dimensioniert werden als die Transistoren 70, 71, so daß eine Ladung des Kondensators 101 in der Vorstufe schneller durchgeführt werden kann, als die Ladung des Kondensators 72 der Schaltung gemäß Fig. 6. Der Grund für die mögliche größere Dimensionierung liegt darin, daß die sich hier ergebenden Spannungsdifferenzen beim Ausschalten des Transistors bedingt durch die parasitären Gate-Drain- und Gate-Source-Kapazitäten nicht so stark auf die restliche Schaltung auswirken, als bei den Transistoren 70 und 71. Bei einer Transferzeit von z. B. 5 µs beträgt dann die Ladezeit des Kondensators 101 der Vorstufenblöcke 2,3 µs.

Fig. 10 zeigt eine erweiterte Vorstufenschaltung für die Schaltung gemäß Fig. 6. Die Videodatensignale 80 werden sowohl einem Transistor 81, als auch einem Transistor 87 zugeführt. Die jeweils andere Elektrode der Transistoren 81, 87 sind einerseits mit Kondensatoren 83, 88, als auch den Eingangselektroden von Transistoren 82, 84 verbunden. Die Ausgänge der Transistoren 82, 84 werden gemeinsam auf den Ladekondensator 72 geführt, dem die Referenzspannung $V_{reframp}$ über den Transistor 75 zugeführt wird, entsprechend Fig. 6.

Mit dieser Vorschaltung kann nun eine ganze Zeile gemäß Fig. 9 dazu benutzt werden, die Vorstufen zu laden, so daß sich eine Ladezeit $t_{load83}$, $t_{load88}$ der Kondensatoren 83/88 von 2,5 µs ergibt. Diese Zeit ist außerdem völlig unabhängig von der Transferzeit $t_{transfer}$. Die Ansteuerungen des Transistors 81 geschieht durch ein Blockumschalten Bu2n jeder 2n-ten Zeile, des Transistors 87 durch ein Blockumschaltsignal Bu2n+1 jeder 2n+1-ten Zeile, des Transistors 82 durch ein Zeilenschaltsignal Z2n+1 jeder 2n-1ten Zeile und des Transistors 84 durch ein Zeilenumschaltsignal Z2n jeder 2n-ten Zeile.

Die Schaltung gemäß Fig. 6 ist je Block 1 - 25 entsprechend der Spaltenzahl pro Block enthalten. Die Eingänge der Gateelektroden der Transistoren 70, 71 werden blockweise parallel geschaltet. Das Kontrollsignal 79 wird nach Schreiben sämtlicher Blöcke 1 - 25 während einer Prozeßzeit angelegt.

## Patentansprüche

1. Ansteuerschaltung für eine Flüssigkristallanzeige, bei der zur Anzeige Pixelelemente mit einer Matrix aus durch Datenleitungen gebildeten Spalten und durch Selektionsleitungen gebildeten Zeilen ansteuerbar sind, wobei jeweils eine Anzahl der Spalten zu Blöcken (1, 2,...,25) zusammengefaßt ist und der entsprechende Teil des anzuzeigenden Signals jeweils parallel über Schalter (26, 27, 28, 70) den Spalten eines Blocks und den Blöcken nacheinander zugeführt wird, wobei für jede Spalte eine das anzuzeigende Signal speichernde Kapazität (35, 36, 37, 65) entsprechend geladen wird und nach Ansteuerung der Blöcke einer Zeile über die Selektionsleitungen die entsprechende Zeile zur Anzeige ausgewählt wird, **dadurch gekennzeichnet,** daß das anzuzeigende Signal zusätzlich in einem jeder der Spalten zugeordneten Ladekondensator (32, 33, 34, 72) zwischengespeichert wird und daß jeweils nach Ladung der Ladekondensatoren einer Zeile über Stromverstärker (44) die Spaltenkapazitäten (35, 36, 37, 65) parallel geladen werden.

2. Ansteuerschaltung nach Anspruch 1, **dadurch gekennzeichnet**, daß in den Stromverstärkern (44) das anzuzeigende Signal in ein pulsbreiten-moduliertes Signal (60) umgesetzt wird, mit dem über eine Zeit-Spannungs-Wandlerschaltung (52; 63, 65) jeweils eine der Spalten angesteuert wird.

3. Ansteuerschaltung nach Anspruch 2, **dadurch gekennzeichnet**, daß das pulsbreiten-modulierte Signal (60) mit Hilfe eines Spannungs-Zeit-Wandlers (73, 74) in einer Transistorschaltung (70, 71, 73, 74, 75) generiert wird, die an einem ersten Eingang (77) die anzuzeigenden Eingangs-Signale für die Datenleitungen und an einem zweiten Eingang (78) eine rampenförmige Referenzspannung ($V_{reframp}$) erhält und in der jeweils einer der Ladekondensatoren (32, 33, 34, 72) angeordnet ist und die entsprechend dem jeweils selektierten Block an einem dritten Eingang ($D_{In}$) aktiviert wird.

4. Ansteuerschaltung nach Anspruch 3, **dadurch gekennzeichnet**, daß das anzuzeigende Signal während einer Ladezeit ($t_{load}$) über eine erste Transistoranordnung (70) mit einem zweiten Transistor (75), an den die Referenzspannung ($V_{reframp}$) angelegt ist, verbunden ist, daß ein erster Verbindungspunkt (A) der ersten und zweiten Transistoren (70, 75) auf den Ladekondensator (72) führt, daß ein zweiter Verbindungspunkt (B) die andere Seite des Ladekondensators mit einem Eingang eines dritten Transistors (71) und der Steuerelektrode eines vierten Transistors (73) verbindet, daß ein dritter Verbindungspunkt (C) der Ausgangs- bzw. Eingangselektroden des dritten und vierten Transistors sowohl mit dem Ausgang (76) der Transistorschaltung als auch mit dem Ausgang eines mit seinem Eingang und seiner Steuerelektrode mit einer Versorgungsspannung (V) verbundenen, fünften Transistors (74) gekoppelt ist.

5. Ansteuerschaltung nach Anspruch 4, **dadurch gekennzeichnet**, daß die erste Transistoranordnung (70) ein Transistor ist.

6. Ansteuerschaltung nach Anspruch 4, **dadurch gekennzeichnet**, daß die Transistoren (70, 71, 73, 74, 75) FET- bzw. TFT-Transistoren sind.

7. Ansteuerschaltung nach einem der Ansprüche 4 bis 6, **dadurch gekennzeichnet**, daß der Kanal des fünften Transistors (74) möglichst klein, der des vierten Transistors (73) möglichst groß gewählt wird.

8. Ansteuerschaltung nach einem der Ansprüche 4 bis 7, **dadurch gekennzeichnet**, daß nach Ladung des Ladekondensators (72) der erste und der dritte Transistor (70, 71) gesperrt wird und über den zweiten Transistor (75) eine Referenzrampe ($V_{reframp}$) an den ersten Verbindungspunkt (A) gelegt wird.

9. Ansteuerschaltung nach einem der Ansprüche 4 bis 8, **dadurch gekennzeichnet**, daß das anzuzeigende Signal für jede Eingangsleitung über einen sechsten Transistor (100) während einer Ladezeit blockweise einem zweiten Kondensator (101) zugeführt wird, daß nach blockweiser Ladung aller zweiten Kondensatoren (101) zeilenweise die gespeicherten Daten an den Eingang des ersten Transistors (70) gelegt werden.

10. Ansteuerschaltung nach Anspruch 4, **dadurch gekennzeichnet**, daß die erste Transistoranordnung (70) aus einer Parallelschaltung mit einem ersten Zweig, der einen siebten Transistor (81), einen dritten Kondensator (83) und einen achten Transistor (82) enthält, und einem zweiten Zweig, der einen neunten Transistor (87), einen vierten Kondensator (88) und einen zehnten Transistor (84) enthält, besteht.

## Claims

1. Control circuit for a liquid crystal display in which pixel elements are controllable, for display purposes, by means of a matrix consisting of columns formed by data lines and rows formed by selection lines, wherein a number of columns is combined into respective blocks (1, 2, ..., 25) and the relevant part of the signal to be displayed is respectively supplied in parallel via switches (26, 27, 28, 70) to the columns of a block and successively to each of the blocks, wherein a capacitor (35, 36, 37, 65) for storing the signal to be displayed is correspondingly charged for each column and, in accordance with the control process of the blocks of a row, the corresponding row for the display is selected via the selection lines, characterised in that, the signal to be displayed is additionally buffer stored in a charging capacitor (32, 33, 34, 72) associated with each of the columns and that, in each case following the charging of the charging capacitors of a row, the column capacitors (35, 36, 37, 65) are charged in parallel via a current amplifier (44).

2. Control circuit in accordance with Claim 1, characterised in that, the signal to be displayed is converted in the current amplifiers (44) into a pulse width modulated signal (60) with which a respective one of the columns is controlled via a time - voltage converter circuit (52; 63, 65).

3. Control circuit in accordance with Claim 2, characterised in that, the pulse width modulated signal (60) is generated with the help of a voltage - time converter (73, 74) in a transistor circuit (70, 71, 73, 74, 75) which receives the input signal that is to be displayed for the data ines at a first input (77) and a ramp shaped reference voltage ($V_{reframp}$) at a second input (78) and in which a respective one of the charging capacitors (32, 33, 34, 72) is disposed and which is activated at a third input ($D_{ln}$) in accordance with the currently selected block.

4. Control circuit in accordance with Claim 3, characterised in that, the signal to be displayed is connected during a charging time ($t_{load}$) via a first transistor arrangement (70) to a second transistor (75) to which the reference voltage ($V_{reframp}$) is applied, that a first connection point (A) of the first and second transistors (70, 75) leads to the charging capacitor (72), that a second connection point (B) connects the other side of the charging capacitor to an input of a third transistor (71) and to the control electrode of a fourth transistor (73), that a third connection point (C) of the output or input electrodes of the third and fourth transistors is coupled to the output (76) of the transistor circuit and also to the output of a fifth transistor (74) which is connected to a supply voltage (V) at its input and its control electrode.

5. Control circuit in accordance with Claim 4, characterised in that, the first transistor arrangement (70) is a transistor.

6. Control circuit in accordance with Claim 4, characterised in that, the transistors (70, 71, 73, 74, 75) are FET or TFT transistors.

7. Control circuit in accordance with any of the Claims 4 to 6, characterised in that, the channel of the fifth transistor (74) is selected to be as small as possible and that of the fourth transistor (73) to be as large as possible.

8. Control circuit in accordance with any of the Claims 4 to 7, characterised in that, the first and the third transistor (70, 71) are blocked after the charging capacitor (72) has charged up and a reference ramp ($V_{reframp}$) is applied to the first connection point (A) via the second transistor (75).

9. Control circuit in accordance with any of the Claims 4 to 8, characterised in that, the signal to be displayed for each input line is supplied blockwise to a second capacitor (101) via a sixth transistor (100) during a charging time, that the stored items of data are applied line-by-line to the input of the first transistor (70) following the blockwise charging of each of the second capacitors (101).

10. Control circuit in accordance with Claim 4, characterised in that, the first transistor arrangement (70) consists of a parallel circuit including a first branch which contains a seventh transistor (81), a third capacitor (83) and an eighth transistor (82) and a second branch which contains a ninth transistor (87), a fourth capacitor (88) and a tenth transistor (84).

**Revendications**

1. Circuit de commande pour un dispositif d'affichage à cristaux liquides où, pour assurer l'affichage, des éléments en pixels sont commandés au moyen d'une matrice composée de colonnes formées par des lignes de données et composée de lignes formées par des lignes de sélection, où un certain nombre de colonnes sont regroupés en blocs (1, 2, ... 25) et où la partie correspondante du signal à afficher est amenée en parallèle aux colonnes d'un bloc par l'intermédiaire de commutateurs (26, 27, 28, 70) avant d'être passée successivement sur les blocs, sachant qu'une capacité (35, 36, 37, 65) mémorisant le signal à afficher est chargée en conséquence pour chaque colonne, et qu'après la commande des blocs respectifs d'une ligne, la ligne en question est choisie pour l'affichage par l'intermédiaire des lignes de sélection, circuit de commande **caractérisé en ce** que le signal à afficher est en outre tamponné dans un condensateur de charge (32, 33, 34, 72) associé à chacune des colonnes, et qu'après le chargement d'un condensateur de charge d'une ligne, les capacités de colonnes (35, 36, 37, 65) sont chargées en parallèle par l'intermédiaire d'amplificateurs (44).

2. Circuit de commande selon la revendication 1 **caractérisé en ce** que, dans les amplificateurs (44), le signal à afficher est transformé en un signal à impulsion modulée en durée (60) qui permet de sélectionner chaque fois une colonne par l'intermédiaire d'un circuit de transformation temps-tension (52 ; 63, 65).

3. Circuit de commande selon la revendication 2 **caractérisé en ce** que le signal à impulsion modulée en durée (60) est généré dans un circuit à transistors (70, 71, 73, 74, 75) au moyen d'un transformateur tension-temps (73, 74), ledit circuit à transistor recevant au niveau d'une première entrée (77) les signaux d'entrée à afficher destinés aux lignes de données, et au niveau d'une seconde entrée (78) une tension de référence en rampe ($V_{reframp}$), l'un des condensateurs de charge (32, 33, 34, 72) étant disposé dans ledit circuit à transistors qui est activé au niveau d'une troisième entrée ($D_{in}$) en fonction du bloc sélectionné.

4. Circuit de commande selon la revendication 3 **caractérisé en ce** que, pendant un temps de chargement ($t_{load1}$), le signal à afficher est connecté par l'intermédiaire d'un premier arrangement transistorisé (70) à un second transistor (75) auquel est appliquée la tension de référence ($V_{reframp}$), qu'un premier point de connexion (A) des premier et second transistors (70, 75) passe sur le condensateur de charge (72), qu'un second point de connexion (B) relie l'autre côté dudit condensateur de charge avec une entrée d'un troisième transistor (71) et avec l'émetteur d'un quatrième transistor (73), qu'un troisième point de connexion (C) des électrodes de sortie et d'entrée des troisième et quatrième transistors est raccordé tant à la sortie du circuit à transistors qu'à la sortie d'un cinquième transistor (74) dont l'entrée et l'émetteur sont branchés sur une tension d'alimentation (V).

5. Circuit de commande selon la revendication 4 **caractérisé en ce** que le premier arrangement transistorisé (70) est un transistor.

6. Circuit de commande selon la revendication 4 **caractérisé en ce** que lesdits transistors (70, 71, 73, 74, 75) sont des transistors à effet de champ ou des transistors TFT.

7. Circuit de commande selon l'une quelconque des revendications 4 à 6 **caractérisé en ce** que le canal du cinquième transistor (74) est choisi aussi petit que possible et celui du quatrième transistor (73) aussi grand que possible.

8. Circuit de commande selon l'une quelconque des revendications 4 à 7 **caractérisé en ce** que les premier et troisième transistors (70, 71) sont bloqués après le chargement du condensateur de charge (72) et qu'une rampe de référence ($V_{reframp}$) est appliquée au premier point de connexion (A) par l'intermédiaire du second transistor (75).

9. Circuit de commande selon l'une quelconque des revendications 4 à 8 **caractérisé en ce** que, par l'intermédiaire d'un sixième transistor (100), le signal à afficher est transmis pour chaque ligne d'entrée bloc par bloc et durant un certain temps de chargement sur un second transistor (101), et qu'après le chargement bloc par bloc de tous les seconds transistors (101), les données enregistrées sont amenées ligne par ligne sur l'entrée du premier transistor (70).

10. Circuit de commande selon la revendication 4 **caractérisé en ce** que le premier arrangement transistorisé (70) est constitué d'un circuit monté en parallèle avec une première branche comportant un septième transistor (81), un troisième condensateur (83) et un huitième transistor (82) d'une part, et avec une seconde branche comportant un neuvième transistor (87), un quatrième condensateur (88) et un dixième transistor (84) d'autre part.

Fig. 1

Fig. 2

Fig. 3

Fig. 4

Fig. 5

EP 0 417 578 B1

D_in

UV

70

71

74

77

A

B

C

76

72

73

Fig. 6

78

75

79

64 μs

$t_{load1}$   $t_{load2}$   . . . .   $t_{load25}$   $t_{process}$

Fig. 8

64 μs

$t_{load83}$   . . . .

n + 1 {

Tf

$t_{load88}$   . . . .

n {

Tf

Fig. 9

EP 0 417 578 B1

Fig. 10

Fig. 7

64 μ

n

$t_{loadV1}$   $t_{loadV2}$   $t_{loadV3}$   . . . . .   $t_{loadV25}$   $t_{tranfer}$

$t_{process}$

n + 1

Fig. 11

Fig. 12

EP 0 417 578 B1